Europäisches Patentamt

European Patent Office

Office européen des brevets

(11) Publication number: **0 484 929 A2**

# EUROPEAN PATENT APPLICATION

(21) Application number: **91118945.4**

(22) Date of filing: **06.11.91**

(51) Int. Cl.5: **H03K 17/16**

(30) Priority: **08.11.90 JP 117480/90**

(43) Date of publication of application:
**13.05.92 Bulletin 92/20**

(84) Designated Contracting States:
**DE FR GB**

(71) Applicant: **PIONEER ELECTRONIC CORPORATION**
**No. 4-1, Meguro 1-chome**
**Meguro-ku Tokyo 153(JP)**

(72) Inventor: **Kawanabe, Yoshihiro, c/o Ohmori Koujou, Pioneer**
**Electronic Corporation, 15-5 Ohmori Nishi 4-chome**
**Ohta-ku, Tokyo(JP)**

(74) Representative: **Bohnenberger, Johannes, Dr. et al**
**Meissner, Bolte & Partner**
**Widenmayerstrasse 48 Postfach 86 06 24**
**W-8000 München 86(DE)**

(54) **Audio signal switching circuit.**

(57) An analogue switch (1a, 1b, 1c) is provided to feed an input audio signal from a tape deck to an amplifier (11). A diode ($D_A$, $D_B$) is provided between a source ($V_{DD}$, $V_{SS}$) and the analogue switch (1a, 1b, 1c) for preventing the input audio signal from flowing to the source ($V_{DD}$, $V_{SS}$) passing through the analogue switch (1a, 1b, 1c), when the source ($V_{DD}$, $V_{SS}$) stops supplying a power to the analogue switch (1a, 1b, 1c).

FIG. 1

EP 0 484 929 A2

## BACKGROUND OF THE INVENTION

The present invention relates to a switching circuit for an audio signal of an audio system.

There is an audio system in which plurality of audio equipments such as a tuner, a tape deck and a CD (compact disk) player and the like are operatively connected to an audio amplifier through an analogue changeover switch to reproduce the sound with a speaker.

In such a system, for example in the tape deck, the amplifier is turned off to monitor the sound with a headphone. However, since the analogue changeover switch is provided in the amplifier, if the amplifier is turned off, a power source of the changeover switch is turned off accordingly. Therefore, a problem arises as described hereinafter.

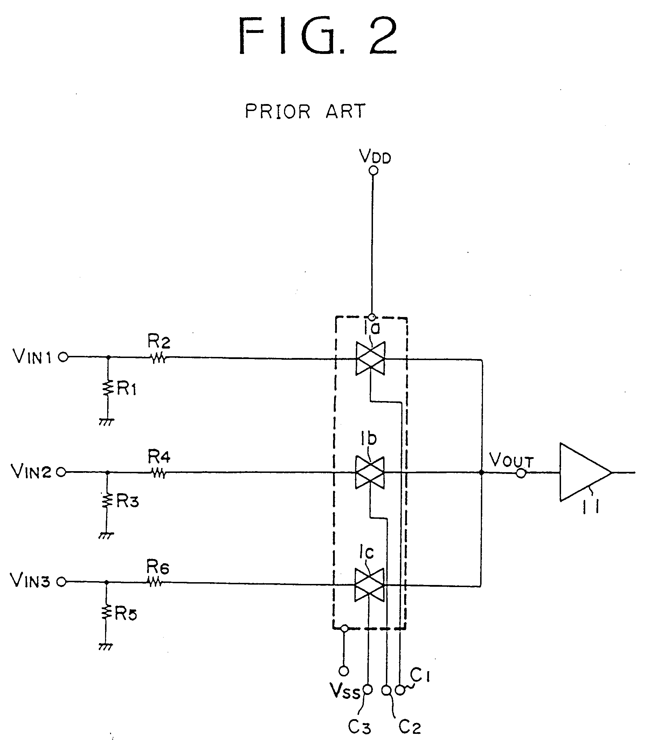

Fig. 2 shows a conventional analogue switching circuit provided in an audio amplifier 11. The switching circuit has a plurality of input terminals VIN1, VIN2, and VIN3 to be connected to output terminals of a plurality of audio equipments such as the tuner, tape deck, and CD player. The input terminals VIN1, VIN2 and VIN3 are connected to analogue switches 1a, 1b and 1c through resistors R2, R4 and R6, respectively. The analogue switches 1a, 1b and 1c have control input terminals C1, C2 and C3, respectively, and an output terminal VOUT which is connected to the audio amplifier 11. Reference marks R1, R3 and R5 are resistors.

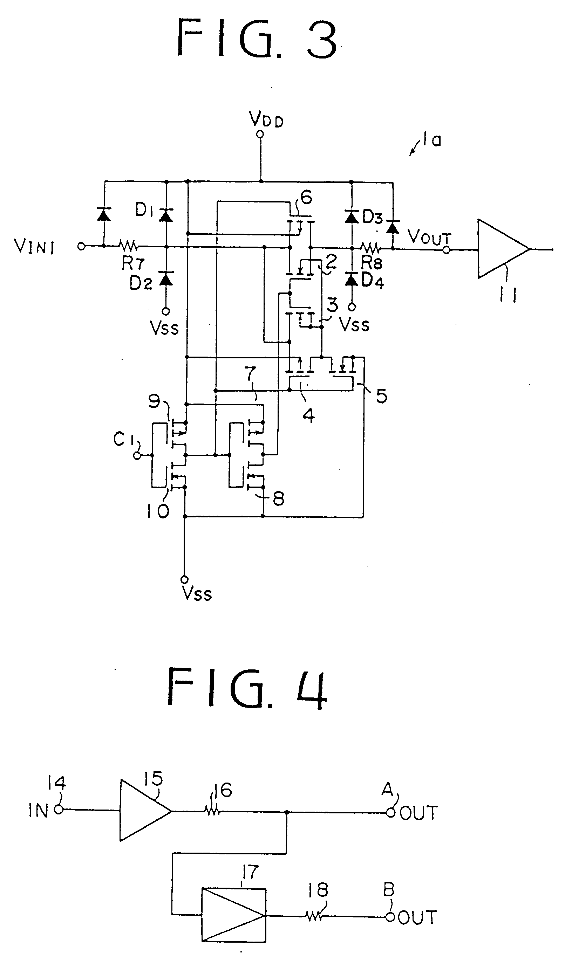

Fig. 3 shows a circuit of the analogue switch, for example the analogue switch 1a. The analogue switch 1a has n-channel FETs 2, 3, 5, 8 and 10, P-channel FETs 4, 6, 7 and 9, protective diodes D1 to D4, and protective resistors R7 and R8.

In the circuit, the voltages of input of the input terminal VIN1, supply source VSS and drain source VDD are determined as VSS ≦ VIN1 ≦ VDD. When a control signal is applied to the analogue switch 1a through the control input terminal C1, the P-channel FETs 9, 7, 6 and 4 become conductive in order. Thus, the input signal of the input terminal VIN1 is fed to the output terminal VOUT from which the signal is applied to the amplifier 11.

If VIN1 > VDD, the input current is fed to the drain source VDD through the protective diode D1. If VIN1 < VSS, the current is fed to the supply source VSS through the protective diode D2. As a result, excessive voltage to the FETs is prevented.

Fig. 4 shows an output system of the tape deck as an example. The output system comprises an input terminal 14 applied with an audio signal reproduced from a magnetic tape, an amplifier 15 for amplifying the input audio signal, a resistor 16 and an output terminal AOUT. Between the resistor 16 and the output terminal AOUT, an amplifier 17, a resistor 18, and an output terminal BOUT for a headphone are provided. The output terminal AOUT is connected to one of the input terminals VIN1, VIN2 and VIN3, in the example, to VIN1.

If the control signal is applied to the analogue switch 1a by the operation of the user, the output of the tape deck is fed to the amplifier 11 through the output terminal VOUT.

In such a system, the headphone is connected to the output terminal BOUT while the amplifier 11 is turned off for listening the sound of the tape with the headphone.

However, if the power source of the amplifier 11 is turned off, the voltage of the drain source VDD becomes zero.

In such a state, if a peak voltage of +0.7V or more is applied from the output terminal AOUT of the tape deck to the input terminal VIN1 of the analogue switch 1a, a current is reversely fed to the drain source VDD through the protective diode D1. If the peak voltage is -0.7V or less, the current is reversely fed to the supply source VSS through the protective diode D2. Therefore, the level of the output signal from the output terminal BOUT is extremely reduced. Consequently, it is difficult to catch the information recorded in the tape. On the other hand, the protective diodes D1 and D2 have non-linear characteristics. Therefore, if each of the protective diodes is conductive, the waveform of the output signal is distorted.

## SUMMARY OF THE INVENTION

An object of the present invention is to provide a switching circuit which eliminates above described disadvantages.

In accordance with the present invention, current blocking means is provided between a source and analogue switch. Consequently, an input signal is prevented from flowing to the source, thereby maintaining the voltage.

In an aspect of the invention, at least one diode is provided for preventing the input audio signal from flowing to the source passing through the analogue switch, when the source stops supplying a power to the analogue switch.

In another aspect, the audio equipment is an amplifier.

The other objects and features of this invention will become understood from the following description with reference to the accompanying drawings.

## BRIEF DESCRIPTION OF DRAWINGS

Fig. 1 shows a switching circuit according to the present invention;
Fig. 2 shows a conventional switching circuit;
Fig. 3 shows a circuit of an analogue switch provided in the switching circuit; and

Fig. 4 is a schematic diagram showing an output system of a tape deck to which the present invention is applied.

DETAILED DESCRIPTION OF THE PREFERRED EMBODIMENT

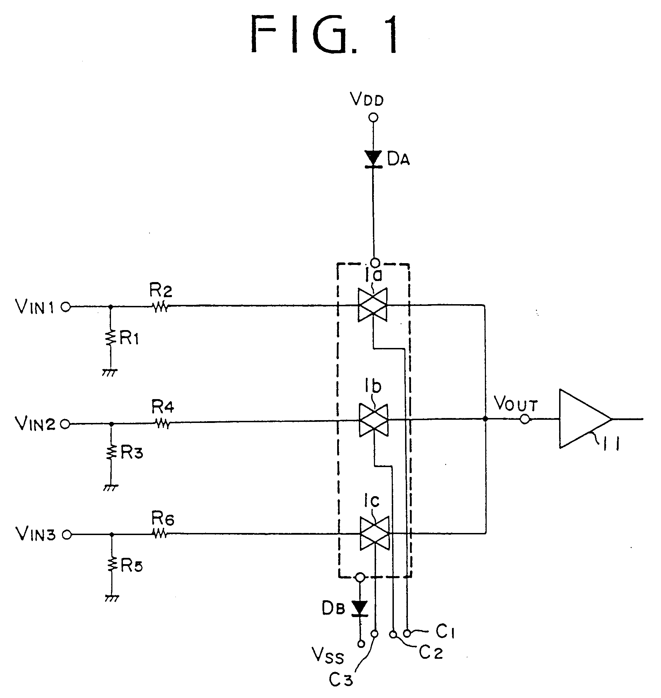

Fig. 1 shows a switching circuit of the present invention, the structure of which is the same as the conventional switching circuit, and identified with the same reference numerals as Fig. 2.

The switching circuit has a plurality of input terminals VIN1, VIN2 and VIN3 to be connected to output terminals of the tuner, tape deck, and CD player. The input terminals VIN1, VIN2 and VIN3 are connected to analogue switches 1a, 1b and 1c through resistors R2, R4 and R6, respectively. The analogue switches 1a, 1b and 1c have control input terminals C1, C2 and C3, respectively, and an output terminal VOUT which is connected to the audio amplifier 11. Reference marks R1, R3 and R5 are resistors.

In the present invention, a pair of reverse current blocking diodes DA and DB are provided between a drain side of the analogue switch 1a and the drain source VDD and between a supply side of the analogue switch 1a and the supply source VSS, respectively. When the control signal is applied to the analogue switch 1a, the output signal of the tape deck is fed to the amplifier 11 through the output terminal VOUT. The voltages are determined $VSS \leqq VIN1 \leqq VDD$.

If the amplifier 11 is turned off, both the sources VDD and VSS become zero. When the peak voltage of the signal applied to the input terminal VIN1 exceed ±0.7V, and the voltage is positive, the current tries to flow to the drain source VDD. However, since the reverse current blocking diode DA acts to prevent the current from flowing to the drain source VDD. If the voltage is negative, the current is prevented from flowing to the supply source VSS by the reverse current blocking diode DB.

The system of the present invention can be used in the other sources such as a TV camera, CD player, LD player, VTR and tuner.

In accordance with the present invention, current blocking means are provided between sources and analogue switches. Consequently, the current is prevented from reversely flowing to the source, thereby preventing the reduction of the voltage and the distortion of the waveform of the output signal.

While the presently preferred embodiment of the present invention has been shown and described, it is to be understood that this disclosure is for the purpose of illustration and that various changes and modifications may be made without departing from the scope of the invention as set forth in the appended claims.

**Claims**

1. An audio signal switching circuit having at least one analogue switch (1a, 1b, 1c) provided to feed an input audio signal to an audio equipment (11),
   characterized by comprising:
   at least one semiconductor device ($D_A$, $D_B$) for preventing the input audio signal from flowing to a source ($V_{DD}$, $V_{SS}$) of the analogue switch (1a, 1b, 1c) passing through the analogue switch, when the source ($V_{DD}$, $V_{SS}$) stops supplying a power to the analogue switch (1a, 1b, 1c).

2. An audio signal switching circuit according to claim 1,
   characterized in that
   the audio equipment is an audio controller or an amplifier (11).

3. An audio signal switching circuit according to one of claims 1 or 2,
   wherein the semiconductor device is a diode ($D_A$, $D_B$) for preventing reverse current.

4. An audio signal switching circuit according to one of claims 1 to 3,
   characterized in that
   the semiconductor device comprises a pair of diodes ($D_A$, $D_B$) disposed opposite sides of the analogue switch (1a, 1b, 1c) in a forward direction with respect to a current for effecting the analogue switch (1a, 1b, 1c).

5. An audio signal switching circuit according to one of claims 1 to 4,
   further comprising a first resistor ($R_2$, $R_4$, $R_6$) connected to an input of the analogue switch (1a, 1b, 1c) in series, and a second resistor ($R_1$, $R_3$, $R_5$) connected between an input side of the first resistor ($R_2$, $R_4$, $R_6$) and the ground.

# FIG. 1

# FIG. 2

PRIOR ART

# FIG. 3

# FIG. 4